Europäisches Patentamt

(19) European Patent Office

Office européen des brevets

(11) Publication number: **0 091 720**
**B1**

(12) **EUROPEAN PATENT SPECIFICATION**

(45) Date of publication of patent specification: **02.07.86**

(21) Application number: **83200517.7**

(22) Date of filing: **12.04.83**

(51) Int. Cl.⁴: **B 65 G 47/91, H 05 K 13/02, H 01 L 21/68**

(54) Method of and device for detecting the presence or absence of an article on or from a vacuum pick-up means.

(30) Priority: **13.04.82 NL 8201532**

(43) Date of publication of application:
**19.10.83 Bulletin 83/42**

(45) Publication of the grant of the patent:
**02.07.86 Bulletin 86/27**

(84) Designated Contracting States:
**AT BE CH DE FR GB IT LI NL SE**

(56) References cited:
**EP-A-0 008 379**
**US-A-3 453 714**
**US-A-3 731 867**

**PATENTS ABSTRACTS OF JAPAN, vol. 5, no. 159(E-77)(831), 14th October 1981**

(73) Proprietor: **N.V. Philips' Gloeilampenfabrieken**
**Groenewoudseweg 1**
**NL-5621 BA Eindhoven (NL)**

(72) Inventor: **Scholten, Gerard Johan**
**c/o INT. OCTROOIBUREAU B.V. Prof. Holstlaan 6**
**NL-5656 AA Eindhoven (NL)**
Inventor: **Beurskens, Theodorus Jacobus Gerardus**
**c/o INT. OCTROOIBUREAU B.V. Prof. Holstlaan 6**
**NL-5656 AA Eindhoven (NL)**
Inventor: **Videc, Mathias Ferdinand**
**c/o INT. OCTROOIBUREAU B.V. Prof. Holstlaan 6**
**NL-5656 AA Eindhoven (NL)**

(74) Representative: **Hartung, Edgar Erwin et al**
**INTERNATIONAAL OCTROOIBUREAU B.V. Prof. Holstlaan 6**
**NL-5656 AA Eindhoven (NL)**

Courier Press, Leamington Spa, England.

## Description

The invention relates to a method of detecting the presence or absence of an article on or from a vacuum pick-up means which can be placed in communication with a vacuum source and which is operable to pick-up, transport and place an article, the article being picked up and held by the pick-up means under the influence of the vacuum and being released when the vacuum is interrupted or destroyed, and the difference in the pressures obtaining in the pick-up means when the latter is in communication with the vacuum source and an article is present on the pick-up means and when the latter is in communication with the vacuum source and there is no article present on the pick-up means, being utilised in the production of a test or failure signal.

For the picking-up, transport, transfer and placement of articles by means of vacuum pick-up means it is desirable, if not necessary, to know:

a. that the article has indeed been drawn to and picked up by the pick-up means;

b. that the article remains attached to the pick-up means over the entire transport path until the instant at which the article is placed;

c. that the article has in fact been placed and left at the appropriate location.

Detection of the presence or absence of an article on or from the pick-up means can be performed in various ways, for example, directly or indirectly by means of sensors, by detection, for instance by mechanical or optical means, of a relative displacement of the pick-up means, or by detection by means of a pressure detector or a flowmeter.

A method of the kind set forth (and defined in the precharacterising part of claim 1) is known from United States Patent Specification 3,453,714; this specification concerns an indirect detection method which utilizes a diaphragm which reacts to a difference in vacuum. A further indirect method which utilizes a differential pressure switch is known from United States Patent Specification 4,116,348. Detection on an optical basis by means of a photocell (again an indirect method) is known from United States Patent Specification 3,731,867. Finally, European Patent Application 0.036.826 discloses a detection method which utilizes a pressure detector as well as an optical detection method. The known detection methods either use a displaceable member and/or react to a differential pressure.

The present invention has for its object to improve upon the known detection methods, to accelerate the detection process itself, and to enhance the reliability of the detection.

This object is achieved in accordance with the invention in that the air flow which is produced by the vacuum when the pick-up means is in communication with the vacuum source and there is no article present on the pick-up means, is utilized to generate the test or failure signal, said air flow being converted into an acoustic signal which indicates the absence of an article from the pick-up means.

Using the method in accordance with the invention, referred to hereinafter as the same detection method, fast detection is achieved in a simple manner, the intensity of the acoustic signal generated a whistling or a noise signal, being a measure of the amplitude of the signal and also a measure of the rate of the air flow. When the vacuum is switched on, a maximum air flow and hence a maximum acoustic signal is to be expected when the free end of the pick-up means is not closed by an article, i.e. when no article is present on the pick-up means; the air flow and hence the acoustic signal are minimum when the pick-up means is closed by an article present thereon.

The article to be picked up and transported may be of various dimensions. For articles having comparatively large dimensions, for example, of the order of magnitude of decimeters, several pick-up means are used; for smaller articles having dimensions of the order of magnitude of millimeters, a single pick-up means will suffice.

The acoustic signal can be generated by means of a whistle or noise generator arranged in the air flow. However, according to a preferred method in accordance with the invention the acoustic signal is produced by turbulence created in the air flow.

The acoustic signal is preferably amplified.

In a further preferred method in accordance with the invention, the acoustic signal is converted into an electric, electronic and/or optical signal.

The invention can be used particularly advantageously for the picking-up, transport and placement as well as for the treatment and handling of electronic and/or electrical components in general.

The increasing degree of miniaturization in the electronics industry has given rise to the development of plate-shaped, block-shaped or cylindrical components without connection wires which components are also referred to as "chip-type" components. These components have comparatively small dimensions of the order of magnitude of millimeters; for example, a frequently used component has the standard dimensions $3.2 \times 1.6 \times 0.8$ millimeters. For the placement of such chip-type components on a substrate, the components are presented in a given position, packed in a given package or not as the case may be, and are picked up by a transfer member to be deposited on the track side of the substrate in the appropriate location; the components are retained in position by means of a fixing agent, such as solder paste or glue, applied to the substrate and/or the components in advance; subsequently, the components are soldered in position by means of a suitable process. Components comprising short connection members, such as diodes or transistors, are transferred to and placed on the substrate in the same manner. Considering the small dimensions of said components, the dense track pattern on the substrate and the required accurate positioning of the components on the substrate, such components can no longer be transported, transferred and placed by means of purely mechanical gripping means such as those customarily used for the handling of conventional components having connection wires. For the handling of chip-type components, generally a vacuum pick-up means is used which is connected to a vacuum source and by means of which a component is picked up in a pick-up position, from a given package or not, after which the pick-up means with the component attached thereto is moved to the mounting position over a substrate and ultimately the component is placed on the substrate by the pick-up means and is retained thereon by a fixing agent, for example, glue or solder paste, applied to the substrate and/ or the component in advance. After removal of the vacuum the pick-up means is moved to the pick-up position again, after which a further component can be picked up and a new cycle may commence.

The invention can be used particularly advantageously for placing electrical and/or electronic components on a substrate, each component being transferred from a pick-up position to a placement position on the substrate by means of a vacuum pick-up means; the picking-up of each component in the pick-up position and the placement of the component on the substrate are checked by means of the sonic detection method according to the invention.

When a comparatively large number of components are to be placed, for example, some tens of components, on the same substrate, it is absolutely necessary to be certain that the components have been picked up, transported and placed. If a single component is not picked up or not actually left on the substrate, the mounting process is liable to be disturbed and an unacceptable rejection percentage may occur; also, unacceptable uncertainty arises as regards the reliable execution of the mounting process. These problems and uncertainties are avoided by using the sonic detection method in accordance with the invention.

In this context the term "substrate" is also to be understood to mean, for example, a tape-like package strip with cavities, chambers or cut-outs in which the components are accommodated. By using the method in accordance with the invention for the packaging of components, it is ensured that each cavity, chamber or cut-out is actually provided with a component.

If desired or if necessary, of course, the presence of the component can also be checked just before it is placed on the substrate. It can thus be detected whether the component has fallen off the pick-up means during the transport from the pick-up position to the placement position.

The sonic detection method in accordance with the invention can also be used to advantage in a mounting process in which each component is temporarily halted in an intermediate position during the transport from the pick-up position to the placement position, a fixing agent being applied to the component in said intermediate position. The presence of the component in the intermediate position can also be checked by means of the sonic detection method in accordance with the invention.

A substrate provided with components by means of the described mounting method is free from placement errors; such errors are to be understood to mean notably positions which are not provided with the component in the desired manner.

The invention also relates to a device for performing the method according to the invention, comprising at least one displaceable vacuum pick-up means which is connected to a vacuum source, and a valve which is operable to establish and interrupt communication between the vacuum pick-up means and the vacuum source. The device in accordance with the invention is characterized in that a sound generator is interposed in the connection between the vacuum pick-up means and the vacuum source. This device will be referred to hereinafter as sonic detector. In one embodiment, the sound generator is constructed simply to produce a whistle. However, the sound generator in a preferred embodiment is constructed as a vortex chamber. The vortex chamber causes turbulence in the air flow produced by the vacuum, said turbulence being accompanied by sound and noise. It is not necessary to create a differential pressure by means of constrictions in this embodiment. Because such a simple sound or noise generator does not comprise moving parts and offers ample passages for the air flow without constrictions, the risk of breakdown due to contamination is very small.

By arranging a microphone in the vortex chamber in a preferred embodiment of the device in accordance with the invention, the sound produced by the turbulent air flow can be simply converted into electronic signals.

In a preferred embodiment of the device in accordance with the invention, the microphone is connected to an electronic signal-processing unit. This unit comprises, for example, a high-pass filter, an amplifier and a threshold-value adjustment device for processing and converting the signals received *via* the microphone into "yes" and "no" signals which are applied to an electronic control device which can influence the mechanical device. Disturbing extraneous sound signals which are not generated by the turbulent air flow are not amplified and transmitted. Examples of such sound signals are speech and music sounds in a frequency range of up to approximately 10,000 Hz. These sound signals are filtered out by the high-pass filter. Adjustment of a threshold value by means of the threshold-value adjustment device enables adjustment of a minimum value of the signal to which the sonic detector must still react. If a component is present on the vacuum pick-up means the sound has a minimum value; if there is no component present the sound has a maximum value. Between a component and the vacuum pick-up means itself, however, always some leakage occurs, because the surface of the component is not absolutely smooth. This fact can be taken into account by adjustment of the threshold value.

Full benefit is derived from the advantages of the described sonic detector in combination with an apparatus proposed in EP—A—71303 in the name of Applicant. This is an apparatus for placing a plurality of electrical and/or electronic components on a substrate and comprises a frame, a drive mechanism, a carrier for a substrate and a transfer mechanism with a plurality of vacuum pick-up means; in such an apparatus the plurality of vacuum pick-up means can be placed in communication with a common vacuum source via a single, common valve. Thanks to its simplicity and resultant reliability, the sonic detector is extremely suitable for multiple use, so that the reliability of the overall device is also improved whilst the costs of the sonic detector are low.

The above mentioned apparatus may comprise a mechanism for the application of a fixing agent to the components, said mechanism comprising a plurality of applicators which are displaceable between a rest position in which the applicators can receive a quantity of fixing agent and an operative position in which they can be brought into contact with the lower sides of the components. Thanks to the sonic detectors, any vacuum pick-up means which does not carry a component for some reason can be prevented from contacting one of the applicators, so that the vacuum duct of the relevant vacuum pick-up means cannot become clogged by the fixing agent.

An example of the method and embodiments of the detection device and the mounting apparatus according to the invention will be described in detail hereinafter with reference to the accompanying drawing, in which:

Figure 1 shows diagrammatically an embodiment of the detection device in accordance with the invention for detecting the presence of an article on or its absence from a vacuum pick-up means;

Figure 1A shows a part of the pick-up means shown in Figure 1;

Figure 2 shows diagrammatically an embodiment of an apparatus for mounting electrical and/or electronic components on a substrate;

Figure 3 is a diagrammatic longitudinal sectional side view, taken along the line III—III in Figure 4, of a transfer device which forms of part of the apparatus shown in Figure 2, the transfer device being shown in the pick-up position;

Figure 4 is a transverse sectional view of the transfer device taken along the line IV—IV in Figure 3;

Figure 5 is a sectional side view, taken along the line V—V in Figure 6, of the transfer device in the mounting position;

Figure 6 is a sectional plan view, taken along the line VI—VI in Figure 5, of the transfer device.

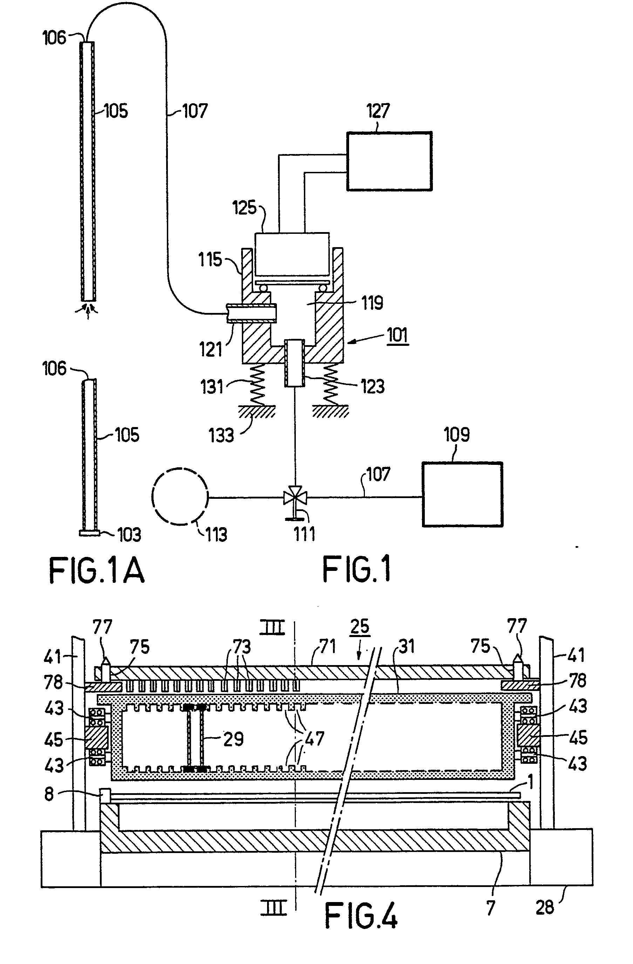

Figure 1 shows diagrammatically a detection device 101 for detecting the presence of an article 103 on, or its absence from a vacuum pick-up means 105 which comprises a suction tube 106.

The pick-up means 105 is connected to a vacuum source 109 via a flexible tube 107. By means of a valve 111, the pick-up means 105 can be placed in communication with the vacuum source 109 or with the ambient atmosphere or a compressed-air source 113. The detection device 101 operates on a sonid basis. To this end, it comprises a noise or sound generator 115, which consists of a vortex chamber 119 with an inlet 121 and an outlet 123 which extend at right angles to one another and which have no constriction. In the vortex chamber 119 there is arranged a microphone 125, preferably an electret microphone, which is connected to an electronic signal-processing unit 127. This unit comprises, for example, a high-pass filter, an amplifier, a rectifier, a smoothing capacitor and a threshold-value adjustment device. The "yes" and "no" signals from the latter device are applied to a control device in the form of optical, acoustic and/or electric signals. The sound generator 115 is mounted on a fixed base 133 by means of resilient or absorbing elements 131.

The operation of the sonic detection device is as follows: For the picking-up, transporting and placement of an article 103, the vacuum pick-up means 105 is connected, via the valve 111, to the vacuum source 109, so that ambient air is drawn into the pick-up means through the free end thereof which is not closed, and an air flow is produced in the suction tube 106 and the tube 107. When the free end of the pick-up means 105 is brought close to or into contact with the article 103 to be picked up, the article is drawn onto the free end of the pick-up means by the air flow and is held thereon by the resulting pressure differential across the article, as shown in Figure 1A. The article 103 can then be transported to the desired location by moving the pick-up means 105. To place the article in the desired location, the vacuum in the suction tube 106 is destroyed by cutting-off the pick-up means 105 from the vacuum source 109 and placing it in communication with atmosphere by means of the valve 111. If desired or if necessary, the pick-up means 105 may be connected to a compressed-air source 113, so that the article 103 is detached from the pick-up means 105 in a positive, i.e. forceful manner. This effect may be important in handling very light articles. The situation in which the pick-up means 105 is connected to the vacuum source 109 without the suction tube 106, for whatever reason, being closed by the article 103, is detected and signalled by the sound or noise generator 115. In this situation air flow in the suction tube 106 and the tube 107 swirls in the vortex chamber 119 due to the acute, abrupt directional change in the air flow between the inlet 121 and the outlet 123. This air turbulence produces sound or noise signals, which signals are received by the microphone 125 and are subsequently amplified by the electronic signal-processing unit 127, after which they are further processed for conversion into electric, acoustic, optical etc. signals. The filter of the unit 127 prevents the transmission of extraneous sounds in an audible frequency range of up to approximately 10,000 Hz; such sounds are filtered out by the filter. Obviously, acoustic signals received by the microphone 125 can be processed to form a positive or a negative indication, *i.e.* the absence or presence, respectively, of an article on or from the end of the pick-up means is signalled in an optical, acoustic or other perceptible manner.

The embodiment shown in Figure 1 concerns a sonic detection device comprising a single pick-up means which is suitable for picking-up a single article. For picking-up, transporting and placing larger articles, a plurality of vacuum pick-up means can be used, each of which comprises a sonic detection device in accordance with the invention and which may or may not be operated together.

The vacuum pick-up means 105 is constructed as a simple suction tube in the embodiment shown. Other embodiments can be used with the same advantages and with the same effect, for example, a vacuum pick-up means of the type comprising a suction tube which is slidable in a tube.

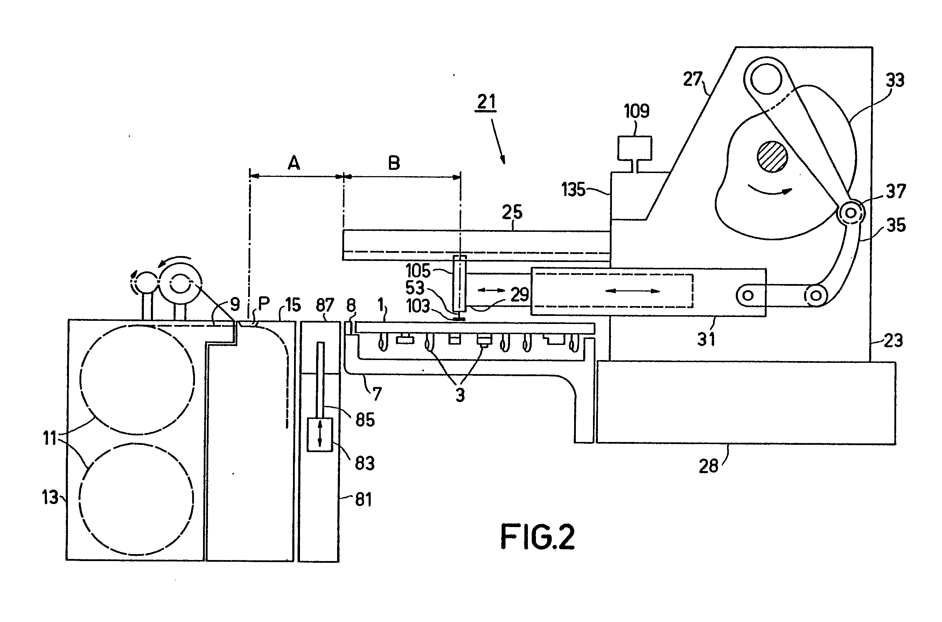

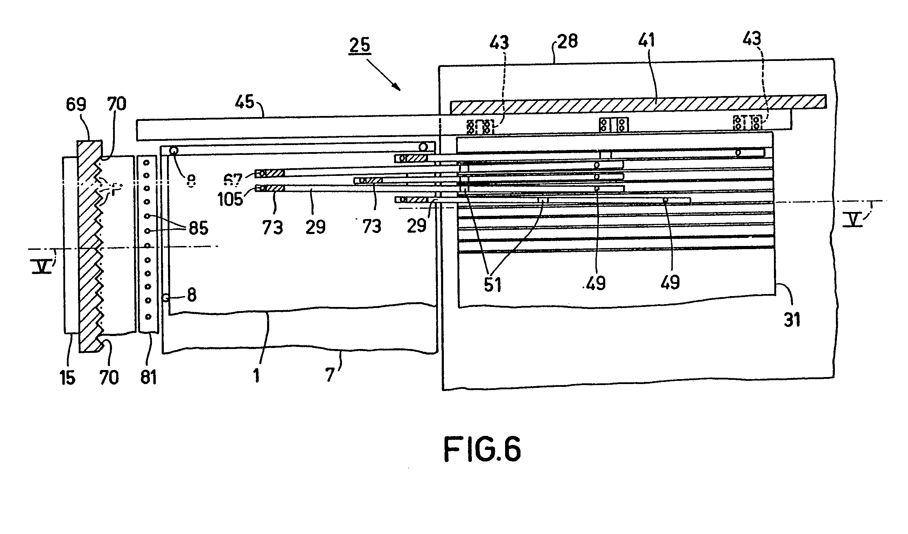

In view of its reliability and low susceptibility to breakdown and contamination and its small dimensions, the sonic detection device in accordance with the invention can be used particularly advantageously in an apparatus for placing and mounting electrical and/or electronic components on a substrate, as shown in the Figures 2 to 6.

The reference numeral 1 in Figure 2 denotes a substrate, for example, a printed-circuit board which is already provided on its lower side with conventional components 3, the lead-outs of which are inserted in holes in the substrate. A large number of further components 103 which are very small and which do not comprise lead-outs are to be placed on the upper side of the substrate. The dimensions of this type of component, also referred to as a "chip" are of the order of magnitude of millimeters and the components must be very accurately positioned on the substrate at a very small distance from one another. Common dimensions of a component are $3.2 \times 1.6 \times 0.8$ mm. The substrate 1 is supported by a substrate carrier 7 which comprises positioning elements 8. The components 103 to be placed are packaged in tapes 9 which comprise feed-sprocket perforations, the components being loosely arranged in openings in the tapes which are closed at the lower side by a lower foil and at the upper side by a cover foil.

A number of these tapes is wound on rotatable reels 11 in a holder 13. The number of reels present in the holder 13 depends on the requirements. It is common to have thirty-two reels arranged at two levels in the holder 13. The tapes 9 extend from the reels 11 to a device 15 (not described) for feeding the tapes to a given pick-up position P. Such a device 15 forms the subject of a previously filed application. In the present embodiment this device is constructed to feed thirty-two components 103 during each cycle. The components 103 are removed from the tapes 9 and transferred to the substrate 1 by a transfer device 21. The device 15 is constructed so that the tapes 9 can be fed to the pick-up position P together or individually. The transfer device 21 consists mainly of a frame 23, a transfer mechanism 25, a drive mechanism 27 and said substrate carrier 7. These parts are mounted on a base 28.

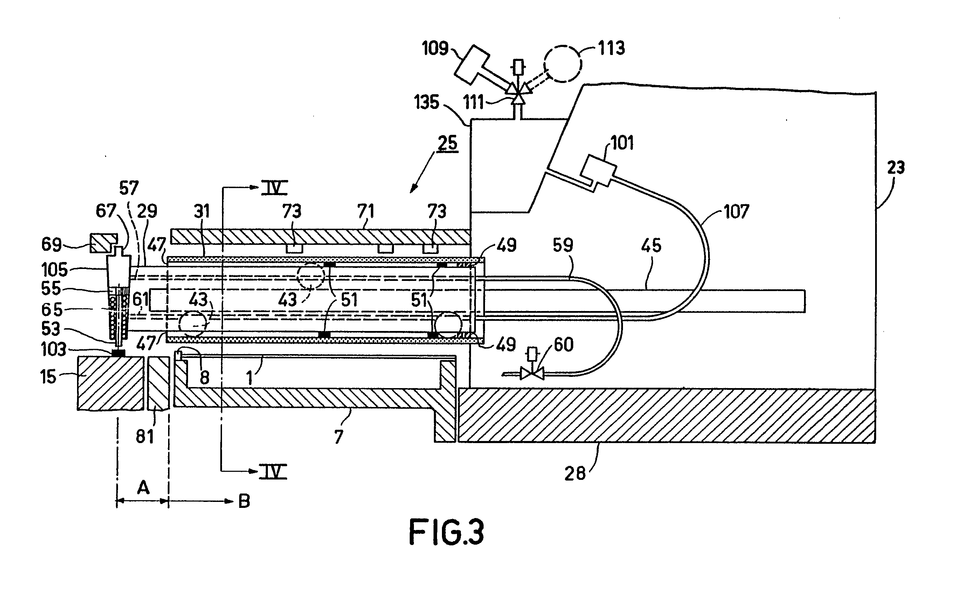

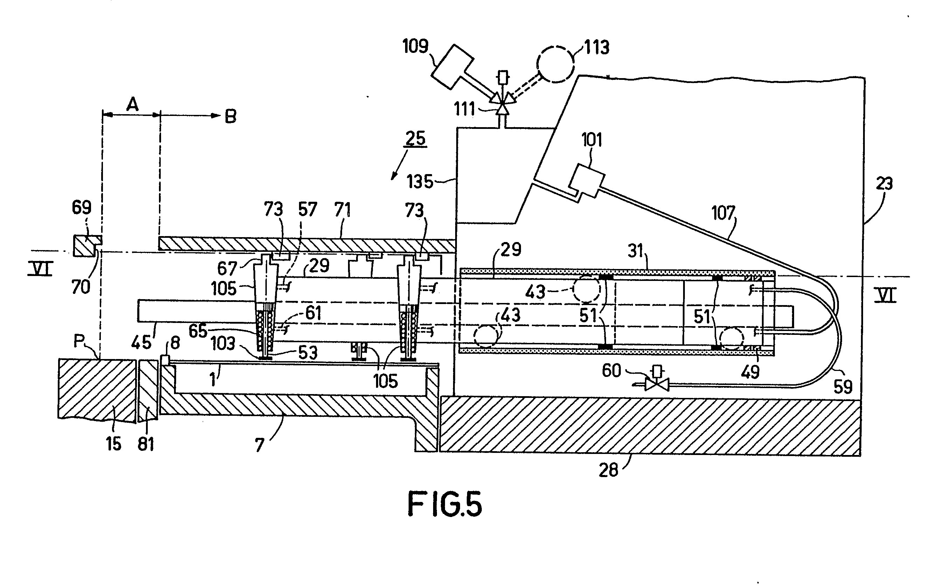

The transfer mechanism 25, which will now be described with reference to Figures 3 to 6, comprises a plurality of transfer arms 29 which are equal in number to the components to be simultaneously transferred, namely, thirty-two in the present embodiment. Each transfer arm 29 comprises a vacuum pick-up means 105. The transfer arms 29 are slidable independently of one another in a single, common carriage 31 which is itself movable in reciprocal directions in the frame 23. The carriage is driven by the drive mechanism 27 which is shown in Figure 2 and which comprises a motor (not shown), a cam disc 33 and a lever 35 with a cam-follower in the form of a roller 37. the frame 23 consists mainly of two sidewalls 41 as shown in Figure 4. The carriage 31 has a tubular form with a rectangular cross-section. In its movement the carriage is guided by rollers 43 which are mounted on the sides of the carriage and which run along two rails 45 which are mounted on the inner sides of the sidewalls 41 and which freely project from the frame 23 beyond the carrier 7. The carriage 31 can thus move freely between the sidewalls 41. In the inner sides of the upper and lower walls of the carriage there are provided parallel grooves 47, thirty-two grooves in each wall in the present embodiment. These grooves 47, in co-operation with ball bearings 49 and sliding blocks 51, to serve to guide in a sliding manner a corresponding number of transfer arms 29. The ball bearings 49, one on the upper side and one on the lower side of each transfer arm, ensure that the transfer arms are supported without play at their rear ends. This support ensures that the vertical position of the transfer arms is maintained. The sliding blocks 51 are so proportioned that some play exists between the transfer arms 29 and the carriage 31 in the transverse direction with respect to the carriage 31, the transfer arms pivoting in this play about vertical axes defined by the ball bearings 49. At its end which is remote from the frame 23 each transfer arm 29 comprises a vacuum pick-up means 105 which is of the type comprising a suction tube in the embodiment shown. The suction tube 53 is displaceable in the vertical direction (Figure 3) by means of a piston 55. Each transfer arm 29 comprises a compressed-air duct 57 which can be connected, *via* an associated flexible tube 59 and an associated electromagnetic valve 60, to a source of compressed air, and which communicates with the space above the piston 55 in the respective pick-up means 105. The electromagnetic valves 60 can be actuated separately so that the suction tubes 53 can be displaced individually. Also in each transfer arm 29 there is provided a vacuum duct 61 which communicates with the respective suction tube 53 and which is connected *via* a flexible tube 107 to a vacuum source 109 in the manner already described with reference to Figure 1, each vacuum duct 61 being connected to the vacuum source *via* a sonic detection device 101 and a common pneumatic chamber 135 to which the vacuum source 109 and possibly also a compressed air source 113 are connected. The reference numeral 111 designates a valve similar to that already mentioned with reference to Figure 1. The suction tubes 53 are each retained in the neutral rest position shown in Figure 3 by a spring 65, the respective transfer arms 29 then being in their pick-up positions and ready to pick-up the components 103 which are in the pick-up position P. In this position, a projection 67 on the upper end of each pick-up means 105 bears against an abutment bar 69 comprising recesses 70 and serving as a multiple fixed abutment. The reference numeral 71 designates a program plate which is replaceably mounted on the frame 23 and which comprises stops 73 which are engageable by the projections 67 on the pick-up means 105 to arrest the transfer arms 29 in the mounting positions shown in Figure 5. As is shown in Figure 4, the program plate 71 is accurately positioned with respect to the frame 23 by means of locating holes 75 which co-operate with locating pins 77. The program plate 71 rests on two elongate supports 78 mounted on the sidewalls 41 of the frame 23.

The reference numeral 81 designates a mechanism for applying a fixing agent or adhesive, such as solder paste or glue, to the lower sides of the components. The mechanism 81 comprises mainly an elongate arm 83 on which is mounted a row of applicators 85, the number of applicators being equal to the number of components to be placed. The arm 83 with the applicators 85 is displaceable in the vertical direction from the rest position shown in Figure 2, in which the applicators 85 are immersed in a container 87 containing fixing agent, to an operative position (not shown) in which the free ends of the applicators 85 can contact the lower sides of the components to be placed.

The cycle of operations of the above apparatus will now be described. First, all thirty-two transfer arms 29 with the thirty-two pick-up means 105 have to be brought to their pick-up positions. To this end, the carriage 31 is moved towards the abutment bar 69 by the drive mechanism 27. The sliding blocks 51 slide in the grooves 47 of the carriage 31 with an accurately defined friction.

The friction is such that when the carriage 31 is driven the transfer arms 29 move with it. However, as soon as the projection 67 of the pick-up means of a transfer arm 29 contacts the abutment bar 69, the relevant arm with its pick-up means is stopped and the arm remains stationary while the carriage 31 continues its movement, the sliding blocks 51 and the ball bearings 41 of the arm remaining stationary in the respective grooves 47 in the carriage 31.

During the displacement of the carriage 31 to the pick-up position, the transfer arms 29 move forward until the projections 67 of all the pick-up means 105 contact the fixed abutment bar 69. The transfer arms are then all stationary in the pick-up positions. The projections 67 and the recesses 70 in the abutment bar 69 are so shaped, proportioned and adjusted that in the pick-up positions of the transfer arms, the centre lines of the suction tubes 53 are situated exactly in one line over the pick-up positions P of the components which are presented in one line.

Subsequently, the suction tubes 53 are displaced downwards by compressed air against the force of the springs 65, the compressed air being supplied *via* the tubes 59 and the compressed-air ducts 57 in the transfer arms 29 by operation of the valves 60. The components 103 present in the pick-up position P are then picked up and held by the respective suction tubes 53 which are connected, *via* the respective vacuum ducts 61 and tubes 107, to the pneumatic chamber 135 which is connected to the vacuum source 109 *via* the valve 111.

Upon interruption of the supply of compressed air to the pick-up means the suction tubes 53 are raised again by the springs 65, and the carriage 31 is then moved backwards by the drive mechanism 47, the transfer arms 29 being taken along with the carriage and bringing the pick-up means 105 to the entry side of the program plate 71. All the pick-up means 105 will then have travelled a first distance A along straight lines parallel to one another, the distance A being the same for all the pick-up means. As has already been described in detail in said previous application in the name of the present Applicants, at the entry side of the program plate 71 there are provided catchor elements (not shown) which lead to the front ends of flexible guide elements. The other end portion of each guide element is secured in an abutment block on the program plate 71 so that a pick-up means 105 is arrested by the relevant stop 73 in a mounting position exactly over the placement position of the component 103, i.e. the position in which the component is to be placed on the substrate 1. The projections 67 on the pick-up means 105 are guided by the guide elements as far as the stops 73, where the transfer arms 29 are arrested by engagement of the projections 67 with the stops 73. The pick-up means will then have travelled a second distance B, with or without lateral displacement. The distance B may be the same for all the pick-up means or it may differ from one pick-up means to another.

**0 091 720**

When all the pick-up means 105 have contacted the relevant stops 73, the suction tubes 53 are moved downwards again by means of compressed air and the components 103 are placed on the substrate 1 by destroying the vacuum in the suction tubes or by connecting the suction tubes to the compressed-air source 113. Subsequently, the supply of compressed air to the spaces above the pistons 55 in the pick-up means 105 is interrupted again and the suction tubes 53 are raised by the springs 65. Finally, the carriage 31 is moved forwards again until all the pick-up means 105 contact the fixed abutment bar 69 again. In the meantime, all the tapes 9 have been advanced one position so that a further component is presented at each pick-up position P.

The detection of the presence of a component on, or its absence from, a pick-up means 105 and of the correct picking-up, the trouble-free transport and the correct placement of the components during the above-described cycle of operations, is effected as follows:

The suction tubes 53 of the pick-up means 105 are in communication with the vacuum source 103 during the picking-up of the components 103 and during the transport of the components until they are left deposited in their placement positions. A first "presence" detection is performed at the picking-up of the components. Should one of the suction tubes 53 fall to pick up a component, for example, because no component is present in the relevant pick-up position P, this is detected and signalled by the associated sonic detection device 101 already described with reference to Figure 1. By means of the control device which forms part of the signal-processing unit 127, the drive for all tapes 9 is blocked, except for the tape 9 which is associated with the empty position and which is individually advanced one position to position a component 103 in the previously empty pick-up position P. The pick-up means 105 whose suction tube 53 is still without a component is pneumatically actuated through the associated the associated valve 60 so that this suction tube performs a downward stroke and picks up the component, whilst the other suction tubes remain in their upper positions. After picking up the component the suction tube is raised by the spring 65 and the cycle is continued by all the pick-up means together. Should several pick-up attempts fail, the apparatus is stopped for further checking.

By performing a further presence detection at the instant at which the pick-up means are located over the respective placement positions on the substrate, the loss of a component from one of the pick-up means during the transport of the component from the pick-up position to the placement position can be detected. The absence of a component is detected and signalled again by the associated sonic detection device 101 which, via the signal-processing unit 127 prevents actuation of the relevant electromagnetic valve 60. The empty suction tube 53 remains in the upper position, whilst the remaining suction tubes are lowered to place their components on the substrate. Subsequently, all the pick-up means are returned to the pick-up position in which the next components in the position P are picked up. The transfer device then performs another mounting cycle during which, however, a component is placed on the substrate only in the placement position which is still empty, the other suction tubes remaining cut off from the compressed-air supply and not being lowered. Subsequently, all the pick-up means return to the pick-up position, where only the suction tube which is then empty picks up a component, after which the normal mounting cycle is resumed.

The sonic detection method can also be used to check whether the components have in fact been left in their placement positions on the substrate. If they have, a signal is supplied by all the detection devices; if no signal is supplied for a particular pick-up means, either the respective component has not been left on the substrate by that pick-up means or the latter's suction tube has become clogged.

In all cases where a particular component is not placed on the substrate in the desired manner for some reason, only one component is mounted, in the above-described manner, during the next mounting cycle.

For fixing the components to the substrate, an adhesive can be applied to the substrate, to the components or to both. The above test makes it possible to check whether adhesive is indeed present on the substrate and/or the component. If it is, the components will normally be retained on the substrate due to the viscosity of the adhesive, in spite of the vacuum in the pick-up means. The indication by the respective sonic detector of the presence of a component on one of the pick-up means at the completion of a mounting cycle thus means that no adhesive was present on the relevant component and/or the substrate.

In order to ensure that all the components are left on the substrate, the pneumatic chamber 135 can be switched over, by means of the two-way valve 111, to the compressed-air source 113 at the instant at which the components are placed on the substrate, so that the vacuum in the pick-up means 105 is destroyed and the suction tubes 53 are also purged. The components are thus ejected as it were, from the suction tubes; at the same time the suction tubes 53 are purged.

In the situations described, suction tubes which do not carry a component are isolated from the supply of compressed air by the respective electromagnetic valves 60. The pistons 55 which displace these suction tubes 53 are consequently retained in their upper, rest positions by the associated springs 65 and are thus prevented from contacting adhesive on the substrate, so that contamination and clogging of the suction tubes by adhesive are prevented. In the same way an empty suction tube is prevented from coming into contact with adhesive on an applicator 85 in the station 81.

In the embodiment described and shown, the suction tubes 53 are moved to their rest positions and retained there by the springs 65. Obviously, pneumatic means can alternatively be used for this purpose.

**Claims**

1. A method of detecting the presence or absence of an article on or from a vacuum pick-up means (105) which can be placed in communication with a vacuum source (109) and which is operable to pick up, transport and place an article, the article being picked up and held by the pick-up means under influence of the vacuum and being released when the vacuum is interrupted or destroyed, and the difference in the pressure obtaining in the pick-up means when the latter is in communication with the vacuum source and an article is present on the pick-up means and when the latter is in communication with the vacuum source and there is no article present on the pick-up means, being utilized in the production of a test or failure signal, characterized in that the air flow which is produced by the vacuum when the pick-up means is in communication with the vacuum source and there is no article present on the pick-up means is utilized to generate the test or failure signal, said air flow being converted into an acoustic signal which indicates the absence of an article from the pick-up means.

2. A method as claimed in Claim 1, characterized in that the acoustic signal is produced by turbulence created in the air flow.

3. A method as claimed in Claim 1 or 2, characterized in that the acoustic signal is amplified.

4. A method as claimed in Claim 1, 2 or 3, characterized in that the acoustic signal is converted into an electric, electronic and/or optical signal.

5. A device for performing the method claimed in one of the Claims 1 to 4, comprising at least one displaceable vacuum pick-up means (105) which is connected to a vacuum source (109) and a valve (111) which is operable to establish and interrupt communication between the vacuum pick-up means (105) and the vacuum source (109), characterized in that a sound generator (115) is interposed in the connection between the vacuum pick-up means (105) and the vacuum source (109).

6. A device as claimed in Claim 5, characterized in that the sound generator (115) is constructed as a vortex chamber (119).

7. A device as claimed in claim 6, characterized in that a microphone (125) is arranged in the vortex chamber (11).

8. A device as claimed in Claim 7, characterized in that the microphone (125) is connected to an electronic signal-processing unit (127).

9. A device as claimed in one of the claims 5 to 8 comprising a plurality of vacuum pick-up means (105), characterized in that the plurality of vacuum pick-up means (105) can be placed in communication with a common vacuum source (109) via a single common valve (111).

**Revendications**

1. Procédé pour détecter la présence ou l'absence d'un objet sur une buse d'aspiration (105) qu'on peut faire communiquer avec une source de vide (109) et est conçue pour saisir, transporter et mettre en place un objet, cet objet étant saisi et retenu par la buse sous l'action du vide et étant lâché lors de l'interruption ou de la suppression du vide, alors que la différence entre, d'une part, la pression régnant dans la buse si celle-ci communique avec la source de vide et un objet est présent sur la buse et, d'autre part, la pression régnant dans la buse si celle-ci communique avec la source de vide et aucun objet n'est présent sur la buse, est utilisée pour engendrer un signal de contrôle ou de défaillance, caractérisé en ce que pour la génération du signal de contrôle ou de défaillance, est utilisé le courant d'air qui est produit par le vide si la buse communique avec la source de vide et aucun objet n'est présent sur la buse, courant d'air qui est converti en un signal acoustique indiquant l'absence d'un objet sur la buse d'aspiration.

2. Procédé selon la revendication 1, caractérisé en ce que le signal acoustique est engendré par création d'une turbulence dans le courant d'air.

3. Procédé selon la revendication 1 ou 2, caractérisé en ce que le signal acoustique est amplifié.

4. Procédé selon la revendication 1, 2 ou 3, caractérisé en ce que le signal acoustique est converti en un signal électrique, électronique et/ou optique.

5. Dispositif pour la mise en oeuvre du procédé selon l'une des revendications 1 à 4, comportant au moins une buse d'aspiration mobile (105) raccordée à une source de vide (109) et une vanne (111) permettant d'établir et d'interrompre la communication entre la buse (105) et la source de vide (109), caractérisé en ce qu'un générateur sonore (115) est interposé dans la communication entre la buse d'aspiration (105) et la source de vide (109).

6. Dispositif selon la revendication 5, caractérisé en ce que le générateur sonore (115) est réalisé sous la forme d'une chambre de tourbillonnement (119).

7. Dispositif selon la revendication 6, caractérisé en ce que dans la chambre de tourbillonnement (11) est disposé un microphone (125).

8. Dispositif selon la revendication (7), caractérisé en ce que le microphone (125) est relié à une unité électronique de traitement de signaux (127).

9. Dispositif selon l'une des revendications 5 à 8, comportant une pluralité de buses d'aspiration (105), caractérisé en ce qu'on peut faire communiquer la pluralité de buses (105) avec une source de vide commune (109) par l'intermédiaire d'une seule vanne commune (111).

**Patentansprüche**

1. Verfahren zum Detektieren der An- oder Abwesenheit eines Gegenstandes an einer Düsenöffnung (105), wobei die Düse mit einer Vakuumquelle (109) in Verbindung gebracht und zum Aufnehmen, Transportieren und Absetzen eines Gegenstandes betrieben werden kann, der unter dem Einfluss des Vakuums von der Düse aufgenommen und festgehalten, und bei Unterbrechung oder Aufhebung des Vakuums freigegeben wird, und wobei der in der Düse entstehende Druckunterschied, wenn einerseits die Düse mit der Vakuumquelle in Verbindung steht und ein Gegenstand an der Düsenöffnung vorhanden ist, und wenn andererseits die Düse mit der Vakuumquelle in Verbindung steht und kein Gegenstand an der Düsenöffnung vorhanden ist, zum Erzeugen eines Prüf- oder Fehlersignals verwendet wird, dadurch gekennzeichnet, dass der Luftstrom, der vom Vakuum erzeugt wird wenn die Düse mit der Vakuumquelle in Verbindung steht und kein Gegenstand an der Düsenöffnung vorhanden ist, zum Erzeugen des Prüf- oder Fehlersignals verwendet wird, wobei der Luftstrom in ein akustisches Signal umgewandelt wird, das die Abwesenheit eines Gegenstandes an der Düsenöffnung anzeigt.

2. Verfahren nach Anspruch 1, dadurch gekennzeichnet, dass das akustische Signal durch im Luftstrom hervorgerufene Turbulenz erzeugt wird.

3. Verfahren nach Anspruch 1 oder 2, dadurch gekennzeichnet, dass das akustische Signal verstärkt wird.

4. Verfahren nach Anspruch 1, 2 oder 3, dadurch gekennzeichnet, dass das akustische Signal in ein elektrisches, elektronisches und/oder optisches Signal umgewandelt wird.

5. Vorrichtung zur Durchführung des Verfahrens nach einem oder mehreren der Ansprüche 1 bis 4, mit zumindest einer verschiebbaren Vakuumdüse (105), die an eine Vakuumquelle (109) angeschlossen ist, und mit einem Ventil (111) zum Herstellen und Unterbrechen der Verbindung zwischen der Vakuumdüse (105) und der Vakuumquelle (109), dadurch gekennzeichnet, dass ein Schallgenerator (115) in der Verbindung zwischen der Vakuumdüse (105) und der Vakuumquelle (109) angeordnet ist.

6. Vorrichtung nach Anspruch 5, dadurch gekennzeichnet, dass der Schallgenerator (115) als Wirbelkammer (119) ausgebildet ist.

7. Vorrichtung nach Anspruch 6, dadurch gekennzeichnet, dass ein Mikrophon (125) in der Wirbelkammer (11) angeordnet ist.

8. Vorrichtung nach Anspruch 7, dadurch gekennzeichnet, dass das Mikrophon (125) an eine elektronische Signalverarbeitungseinheit (127) angeschlossen ist.

9. Vorrichtung nach einem oder mehreren der Ansprüche 5 bis 8, mit einer Vielzahl von Vakuumdüsen (105), dadurch gekennzeichnet, dass die Vielzahl von Vakuumdüsen (105) über ein einziges gemeinsames Ventil (111) mit einer gemeinsamen Vakuumquelle (109) in Verbindung gebracht werden kann.

FIG.1A    FIG.1

FIG.4

FIG.2

0 091 720

FIG.3

FIG.5

FIG.6